# EUROPEAN PATENT APPLICATION

(11) **EP 1 550 528 A1**
(43) Date of publication of application: **06.07.2005**
(21) Application number: 03079210.5
(22) Date of filing: 30.12.2003
(51) Int. Cl.: B23K 26/067, B23K 26/08, B23K 26/38, H01L 21/78, H01L 21/304, G02B 27/10, G02B 27/42, G02B 3/00, G02B 3/08, B23K 26/00

(54) **Method, device and diffraction grating for separating semiconductor elements formed on a substrate by altering said diffraction grating**

(71) Applicant: Advanced Laser Separation International (ALSI) B.V., 6641 TL, Beuningen (NL)
(72) Inventor: Van der Laak, Hendrikus Petrus, 6641 TL Beuningen (NL); Chall, Hans Peter, 6641 TL Beuningen (NL)
(74) Representative: Valkonet, Rutger

(57) **Abstract**

The present application discloses a method of separating semiconductor elements formed in a wafer (12) of semiconductor material using a laser (1) producing a primary laser beam (2). Said at least one primary laser beam (2) is split into a plurality of secondary laser beams (5) using a first diffraction grating (4) having at least a first grating structure relative to said wafer (12), by impinging said at least one primary laser beam (2) on said first grating structure (4). At least one first score is formed by moving said laser beam (5) relative to said wafer (12) in a first direction. The method further comprises a step of forming at least one second score by moving said laser beam (5) relative to said wafer (12) in a second direction (17). Before the step of moving said laser beam (5) relative to said wafer (12) in the second direction (17), the method comprises a step of altering said first grating structure (4) to a second grating structure relative to said wafer (12). In addition, an arrangement and diffraction grating (4,14) for use in this method are also disclosed.

## Description

### Field of the invention

The present invention generally relates to a method, device and diffraction grating for separating semiconductor elements formed on a substrate, such as semiconductor elements formed in a wafer of semiconductor material using a laser, and in particular to a method, device and diffraction grating for separating semiconductor elements formed in a wafer of semiconductor material using a laser producing a primary laser beam, wherein said primary laser beam is split into a plurality of secondary laser beams using a first diffraction grating having at least a first grating structure and by impinging said primary laser beam on said first grating structure, and wherein at least one first score is formed by moving said laser relative to said wafer in a first direction, the method further comprising a step of forming at least one second score by moving said laser relative to said wafer in a second direction.

### Background of the invention

It is common in industry to form semiconductor elements such as diodes, transistors, integrated circuits comprising a plurality of diodes and transistors and passive components, such as capacitors, on wafers of semiconductor material. These semiconductor elements are generally separated from each other by diamond cutting or other mechanical cutting methods; in some cases laser dicing or laser cutting techniques are used. Similar separation techniques are, for instance, for manufacturing semiconductor devices such as CCD-devices, wherein semiconductor elements (e.g. semiconductor cells) are coated with a ceramic material (glass), and separated as a whole.

U.S. patent 5,922,224 assigned to the assignee of the present patent application, discloses a laser separation technique whereby a score is formed in the surface of a wafer of semiconductor material by local evaporation and/or melt ejection of semiconductor material through heating by means of radiation generated by a laser. Therefore a primary laser beam is directed onto a diffraction grating for splitting the beam into a plurality of secondary laser beams. These secondary laser beams are aimed at the wafer and are focussed in one or more focal points. By relative movement between the wafer and the laser beam, one or more scores are formed depending on the number of focal points. Each score which is formed corresponds to a focal point on the surface of the wafer. The relative movement may be achieved by moving the laser, moving the wafer or moving both the wafer and the laser, as will be appreciated.

Note that in a method as described above, more than one secondary laser beam may be directed to one focal point. The depth and the spatial form of the score or groove formed in the wafer may be dependent on the orientation of the one or more secondary laser beams relative to the surface of the wafer. A secondary laser beam impinging on the surface oblique thereto, may form grooves with side walls oblique (rather than perpendicular) to the surface.

In general the semiconductor elements formed on the wafer are distributed over the surface in a certain surface pattern which enables straightforward cutting by providing a suitable relative movement between the laser and the wafer. Such a pattern may for instance be a matrix pattern, wherein the wafer may be diced by forming a plurality of parallel scores in a first direction, for instance between each row of semiconductor elements, and subsequently forming a plurality of scores in a second direction, for instance between each column of semiconductor elements. It will be understood that for a matrix distribution of semiconductor elements, when the wafer is ready cutting in the first direction, a relative movement between the wafer and the laser in the perpendicular direction is required in order to form the scores in de second direction.

As a result of the splitting of the primary laser beam into the plurality of secondary laser beam and re-focussing of these secondary laser beams onto the wafer surface, the pattern of focal points and the orientation of the secondary laser beams relative to the wafer surface becomes dependent on the cutting direction. If for instance two focal points are formed on the surface for forming two scores on the wafer at a given distance from each other in the first direction, the pattern of the two focal points on the wafer surface must be adapted in the second direction in order to maintain the given distance between the scores. Similarly, in case one or more secondary beams impinge on the wafer surface obliquely thereto, the orientation of the secondary beams must be adapted in order to maintain the orientation of the secondary beam relative to the score to be formed in the second direction.

This may be achieved by rotating the wafer relative to the laser for suitably aligning the secondary laser beams and one or more focal points such that a desired plurality of parallel scores in the second direction may be formed by moving the laser relative to the wafer. In the example of a matrix distribution of semiconductor elements this may be achieved by rotating the wafer over an angle of 90 degrees before forming the scores in the second direction.

Rotation of the wafer must be performed sufficiently accurate over a desired angle. To a certain degree, variations in the rotating angle are inevitable. These variations determine the boundaries of efficiency of the method, as it will be understood that variations in the rotating angle of the wafer will result in variations in the cutting direction. Since the laser is moved relative to the wafer, the actual score formed will deviate from the desired or intended score, and this deviation will grow over the distance travelled by the laser relative to the wafer.

In industry this may be anticipated by providing a so called scribing lane, which is a region in between each of the rows and columns of semiconductor elements formed on the wafer, wherein the score may be formed. A variation in the cutting direction will not directly result in the loss of semiconductor elements if the scribing lane is chosen to be broad enough. However, the dimensions of the scribing lane (broadness) determines to some extend the number semiconductor elements that can be formed on the surface of the wafer. As will be appreciated, the scribing lanes must therefore be as small as possible. It will therefore be understood that a lot of effort is put in accurate rotation of the wafer, such that the variations in rotation angle are as small as possible. This slows down the separation process.

Another disadvantage is that the pattern of focal points and the orientation of the secondary laser beams relative to the wafer surface is determined by the characteristics of the diffraction grating. It is therefore not possible to amend this pattern during the process without interrupting the process and replacing the diffraction grating.

### Summary of the invention

It is an object of the present invention to provide a method for separating semiconductor elements, which alleviates the abovementioned problems, which enables accurately forming scores in either direction and which enables amending the pattern of focal points of secondary laser beams during the process.

This is achieved by the present invention by providing a method of separating semiconductor elements on a substrate, such as semiconductor elements formed in a wafer of semiconductor material, using a laser producing at least one primary laser beam, wherein said at least one primary laser beam is split into a plurality of secondary laser beams using a first diffraction grating having at least a first grating structure and by impinging said at least one primary laser beam on said first grating structure, and wherein at least one first score is formed by moving said laser relative to said substrate in a first direction, said method further comprising a step of forming at least one second score by moving said laser relative to said substrate in a second direction, characterised in that, before said step of moving said laser relative to said substrate in said second direction, said method comprises a step of altering said first grating structure to a second grating structure.

By altering the first grating structure to a second grating structure for use in the second direction, it is no longer required to use the same diffraction grating structure for both the first and the second direction. Therefore, a suitable direction grating structure may be used for the first direction and another suitable grating structure may be used for the second direction; each of the first and second grating structures adapted to the requirements of the direction wherein they are used. The second grating structure may, for instance, simply be a rotated mathematical image of the first grating structure, or may alternatively be a completely different grating structure. This enables moving the wafer (or the laser) in a different direction (e.g. sideways instead of back and forth), without having to rotate the wafer relative to the laser first and without having to replace the diffraction grating. Variations in the rotation angle and/or cutting direction caused by rotation of any element relative to any other element in the process are thereby anticipated. The scores to be formed in the wafer dicing method may therefore be placed more accurate, and the required scribing lanes can be made smaller than in conventional wafer dicing methods. As a result, the density of semiconductor elements on the wafer surface may be increased, which reduces the costs of production.

The method may be applied to method for separating semiconductor elements from a wafer of semiconductor material. In addition, the method may be used for manufacturing CCD-devices. Alternatively, the method of the invention may, for instance be applied to separating other substrates comprising semiconductor elements, such as semiconductor elements formed on substrates of an insulating material.

Altering the first grating structure into a second grating structure may be achieved in various ways. In an embodiment of the present invention said step of altering said first grating structure comprises translating said first diffraction grating, such that said primary laser beam impinges on said second grating structure.

As will be appreciated by those skilled in the art altering the first grating structure into a second grating structure may be performed relatively easy by providing a translational movement of the diffraction grating. The pattern of focus points and the orientation of secondary laser beams may be adjusted accurately, since the aligning of the first and second grating structure in the plane perpendicular to the laser can be preset accurately. A translation of said diffraction grating in said plane will not alter the alignment of the first and second grating structure relative to each other and relative to the wafer surface.

The second grating structure may either be provided on the first diffraction grating, for instance if the first diffraction grating provides different surface regions having different grating structures, or by providing said second grating structure on a second diffraction grating.

Said second grating structure may be different grating structure than said first grating structure, or alternatively, in an embodiment of the invention, said first and second grating structures are chosen such that said second grating structure is a mathematical image of said first grating structure by rotating said first grating structure over a rotation angle.

This provides the benefit that when similar scores are to be formed in the first and in the second direction, having for instance similar distances in between each score, a similar depth, etcetera, a mathematical image of the first grating structures may be used as the second grating structure, for instance a mathematical rotation of the first grating structure over a certain angle in the plane of the grating. A clear example is the case wherein the semiconductor elements on the wafer are distributed in a matrix distribution, having elements on equal distances in each column and each row of the matrix. In fact, the grating structure that is used for forming the scores in between each of the columns (in the first direction) may be used for forming the scores in between each of the rows (in the second direction) by mathematically rotating the first grating structure over an angle of 90 degrees in the plane of the diffraction grating (note that this rotation angle is equal to the angle between the first and the second direction).

There are several ways of implementing the above embodiment. One may for instance use a single diffraction grating having a first and a second diffracting grating structure, wherein the first and the second grating structure are the same but are aligned under an angle (e.g. perpendicular). An example of this may be a fish bone structure wherein the first grating structure exists of a plurality of parallel lines in one direction and the second grating structure consists of a plurality of lines in the second direction perpendicular to the first direction.

In another embodiment, the first diffraction grating is rotated over an axis of rotation which is transverse to the primary laser beam. The diffraction grating is in other words "flipped over".

It will be appreciated that the axis of rotation transverse to the primary laser beam may be chosen such, that rotating the first diffraction grating around this axis of rotation over 180 degrees will provide a second grating structure, wherein the grating lines are perpendicular to the lines of the first grating structure in the plane which is perpendicular to the primary laser beam.

It will be appreciated that another possibility for altering the first grating structure to the second grating structure comprises rotating said first diffraction grating relative to an axis of rotation parallel to said primary laser beam. Said rotation should be performed accurately over the desired angle of rotation.

According to a second aspect the present invention provides a device for separating semiconductor elements formed on a substrate, such as semiconductor elements formed in a wafer of semiconductor material, comprising a laser arranged for producing at least one primary laser beam, a first diffraction grating having at least a first grating structure, said first diffraction grating arranged for splitting said at least one primary laser beam into a plurality secondary laser beams by impinging said at least one primary laser beam onto said first grating structure, means arranged for moving said substrate relative to said laser in at least a first direction for forming a first score, said means arranged for moving being further arranged for moving said substrate relative to said laser a second direction for forming a second score, characterised in that, said device further comprises means arranged for altering said first grating structure to a second grating structure.

In the third aspect of the present invention there is provided a diffraction grating produced in a method or device as described above, said diffraction grating comprising a first part having a first grating structure and a second part having a second grating structure.

The present invention will now further be elucidated by a description and drawings referring to preferred embodiments thereof, directed to a method and arrangement for separating a semiconductor element formed on the surface of a wafer, wherein the semiconductor elements are distributed over the wafer in a matrix distribution, such that the first and second direction as described above are perpendicular to each other. The invention is not limited to the embodiments disclosed; the embodiments are provided for explanatory purposes only.

### Brief description of the drawings

Figure 1 shows an arrangement according to the present invention.
Figure 2A-C shows several diffraction gratings for use with the present invention.
Figure 3 shows a step of rotating a diffraction grating for altering a first grating structure into a second grating structure.

### Detailed description of the drawings

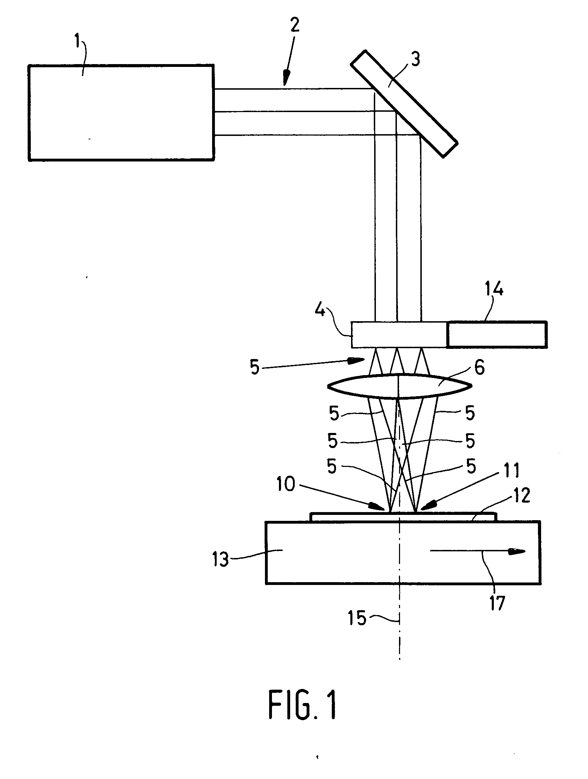

Figure 1 shows an arrangement for using a method according to the present invention, wherein a laser 1 provides plurality of primary laser beams 2, which are directed using a mirror 3 to impinge on a diffraction grating 4. The diffraction grating 4 splits the primary laser beams 2 into a plurality of secondary laser beams 5. The secondary laser beams 5 are focussed by an optical element (objective) into a plurality of focal points 10 and 11 onto the surface of a wafer 12. The wafer 12 is supported by a table 13. Note that axis 15 shows the optical axis perpendicular to the wafer, parallel to the primary laser beam.

In order to separate semiconductor elements from the wafer surface a plurality of scores formed in focal points 10 and 11 are formed by moving the primary laser beams 2 relative to the wafer 12, supported by table 13. This may either be achieved by moving the table 13 with the wafer 12 and maintaining the optical components (1, 3, 4, 6 and 14) in place, or by moving the optical components and maintaining the table 13 in place, or both moving the table 13 and the optical components.

When a plurality of scores in a first direction are formed on the wafer surface, and the laser has finished moving relative to the wafer in the first direction, the primary laser beams 2 may be moved relative to the wafer surface 12 in a second direction, perpendicular to the first direction, for forming a plurality of scores in the second direction. It will be apparent that somehow the focal points 10 and 11 must be formed in different locations due to the change of direction. For instance, if the first direction of the wafer 12 relative to the primary laser beams 2 is in the direction perpendicular to the paper, and the second direction is parallel to the paper, as indicated by arrow 17, it is apparent that in the first direction focal point 11 follows the trail of focal point 10, while in the second direction focal points 10 and 11 travel trajectories that are parallel to each other at a certain distance from each other. It will be understood that this may not be a desired situation; for instance, it may be desired to have focal point 11 follow focal point 10 in exactly the same manner while moving the laser relative to the wafer in the second direction as is done in the first direction. Alternatively, a completely different orientation of the secondary laser beams 5, resulting in a different pattern of focal points on the wafer surface, may be desired in the second direction, compared to the first direction.

Changing the location of the focal points 10 and 11 may for instance be achieved by providing a second diffracting grating 14 having a second grating structure, and by shifting the first grating structure 4 away from the primary laser beams 2, whilst shifting diffraction grating 14 into the primary laser beams 2, such that the primary laser beams 2 impinge on the second grating structure. The second grating structure formed on second diffraction grating 14 may be different from the first grating structure on diffraction grating 4. Therefore, the plurality of secondary laser beams 5, formed by impinging the primary laser beams 2 on the diffraction grating 14, may be oriented and directed in different directions as a result of the second grating structure. The second grating structure formed on diffraction grating 14 may be chosen such that the focal points formed therewith are arranged for forming a plurality of (equidistant) scores in the second direction.

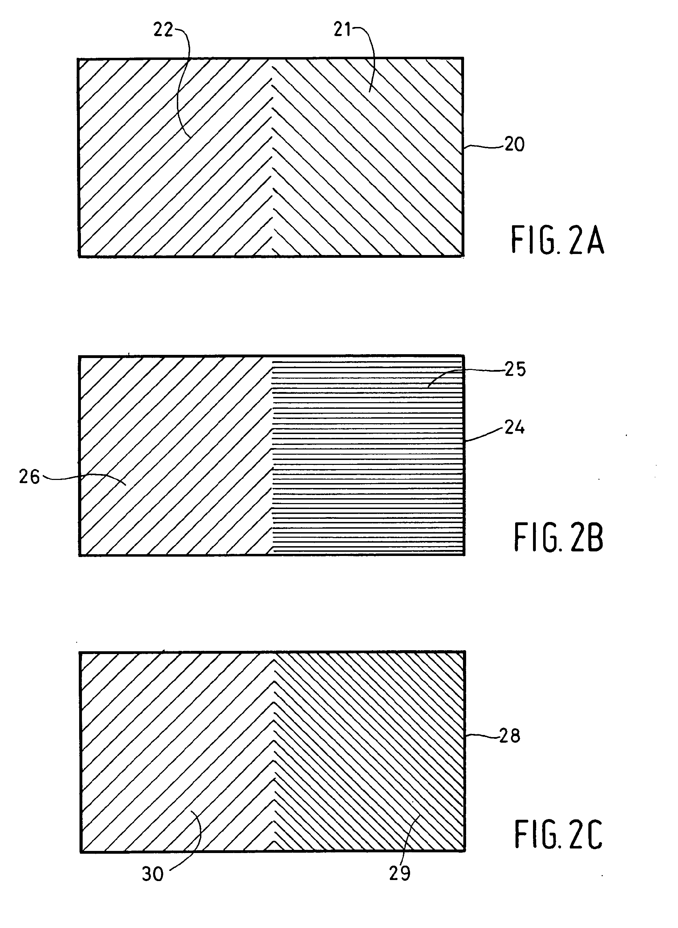

The diffraction gratings 4 and 14 comprising the first and second grating structures respectively may consist of two different diffraction gratings as indicated in figure 1, or may alternatively be formed by one diffraction grating comprising the first and the second grating structure in different regions of the surface thereof. Some examples of such a diffraction grating are shown in figures 2A, 2B and 2C.

Figure 2A shows a so called fish bone grating, consisting of two grating structures on the surface thereof. The first grating structure 21 and the second grating structure 22 on the surface of fish bone grating 20, are similar to each other with respect to the distance between the plurality of parallel grating lines. However, second grating structure 22 forms a mathematical image of first grating structure 21 by rotating second grating structure 22 over exactly 90 degrees.

A fish bone grating as shown in figure 2A may be used for separating a plurality of semiconductor elements formed on the surface of a wafer, which semiconductor elements are distributed in a matrix distribution pattern. Each of these semiconductor elements may have the form of a square, and each column and each row of the matrix is comprised of a plurality of these semiconductor elements. In between each of the rows and each of the columns there is comprised a scribing lane for forming a score. It will be appreciated that by using fish bone grating 20 as shown in figure 2A it is not necessary to rotate the wafer relative to the primary laser beams when the arrangement is ready moving in the first direction. Grating 20 can be shifted such that the primary laser beams may impinge on any desired grating structure 21 or 22.

Figure 2B shows an alternative embodiment of a diffraction grating that may be used with the present invention, wherein a first grating structure 25 and a second grating structure 26 are formed on the surface of a diffraction grating 24. It will be appreciated that the pattern of secondary laser beams formed by first grating structure 25 is completely different from the pattern of secondary laser beams formed with second grating structure 26. It will further be appreciated that different diffraction gratings can be designed for different wafer dicing requirements. In case a wafer comprises a plurality of semiconductor elements which are not distributed in a matrix distribution as described above in relation to figure 2A, any collection of first and second (and possibly third, forth...n^{th}) grating structures may be formed on the surface of a diffraction grating in order to provide a suitable pattern of secondary laser beams arranged for cutting in any desired direction.

In figure 2C another embodiment of a fish bone grating 28 is shown, wherein a first grating structure 29 comprises a plurality of parallel grating lines, and a second grating structure 30 comprises a plurality of grating lines perpendicular to the first grating structure. Note that the grating structure lines in the first grating structure are much closer to each other than the grating lines in the second grating structure.

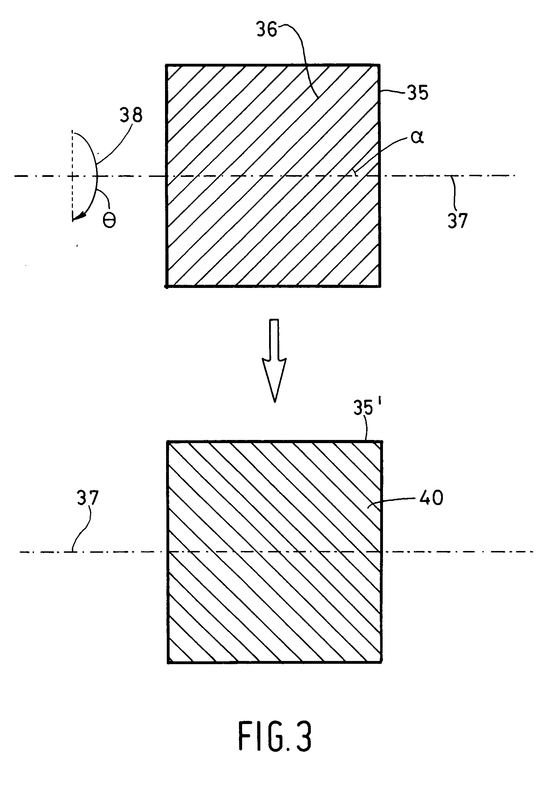

Altering the first grating structure into a second grating structure may also be achieved by "flipping" a conventional diffraction grating "over", as shown in figure 3 of the application. The top part of figure 3 shows a conventional diffraction grating 35 which is comprised of a first grating structure 36. An axis of rotation 37 parallel to the surface of the grating is chosen such that the angle α of the axis of rotation 37 and the lines of the grating structure 36 is equal to half the angle over which the first grating structure 36 must be rotated in the plane of the paper, in order to form a second grating structure 40. The second grating structure 40 is then achieved by rotating the diffraction grating 35 over an angle θ equal to 180 degrees, around axis of rotation 37. This is indicated by the arrow 38. The bottom part of figure 3 shows the result of this rotation. Here the same grating (indicated as 35') is shown comprised of a second grating structure 40. In fact, the second grating structure 40 is achieved by rotating the diffraction grating 35 around axis of rotation 37, such that the "back" side of the grating becomes the "front" side and vice versa. For reference, axis of rotation 37 is shown in the bottom part of figure 3 as well.

For the purpose of comprehensiveness, it is noted here that numerous modifications and variations of the present invention are possible in the light of the above teachings. It is therefore understood that, within the scope of the amended claims, the invention may be practised otherwise than as specifically described herein.

## Claims

1. Method of separating semiconductor elements on a substrate, such as semiconductor elements formed in a wafer of semiconductor material, using a laser producing at least one primary laser beam, wherein said at least one primary laser beam is split into a plurality of secondary laser beams using a first diffraction grating having at least a first grating structure and by impinging said at least one primary laser beam on said first grating structure, and wherein at least one first score is formed by moving said laser relative to said substrate in a first direction, said method further comprising a step of forming at least one second score by moving said laser relative to said substrate in a second direction, **characterised in that**, before said step of moving said laser relative to said substrate in said second direction, said method comprises a step of altering said first grating structure to a second grating structure.

2. Method according to claim 1, wherein said step of altering said first grating structure comprises translating said first diffraction grating, such that said at least one primary laser beam impinges on said second grating structure.

3. Method according to claim 2, wherein said second grating structure is comprised by said first diffraction grating.

4. Method according to claim 2, wherein said second grating structure is formed on a second diffraction grating.

5. Method according to any of the previous claims, wherein said first and second grating structures are chosen such that said second grating structure is a mathematical image of said first grating structure by rotating said first grating structure over a rotation angle.

6. Method according to claim 5, as dependent on claim 1, wherein said step of altering said first grating structure comprises rotating said first diffraction grating for forming said second grating structure.

7. Method according to claim 6, wherein said step of rotating said first diffraction grating comprises rotating relative to an axis of rotation transverse to said at least one primary laser beam.

8. Method according to claim 6, wherein said step of rotating said first diffraction grating comprises rotating relative to an axis of rotation parallel to said at least one primary laser beam.

9. Method according to any of the previous claims, wherein said second direction is transverse to said first direction.

10. Device for separating semiconductor elements formed on a substrate, such as semiconductor elements formed in a wafer of semiconductor material, comprising a laser arranged for producing at least one primary laser beam, a first diffraction grating having at least a first grating structure, said first diffraction grating arranged for splitting said at least one primary laser beam into a plurality secondary laser beams by impinging said at least one primary laser beam onto said first grating structure, means arranged for moving said substrate relative to said laser in at least a first direction for forming a first score, said means arranged for moving being further arranged for moving said substrate relative to said laser a second direction for forming a second score, **characterised in that**, said device further comprises means arranged for altering said first grating structure to a second grating structure.

11. Device according to claim 10, wherein said means arranged for altering said first grating structure are arranged for translating said diffraction grating relative to said at least one primary laser beam, such that said at least one primary laser beam impinges on said second grating structure.

12. Device according to claim 11, wherein said second grating structure is comprised by said first diffraction grating.

13. Device according to claim 11, further comprising a second diffraction grating comprising said second grating structure.

14. Device according to any of the claims 10-13, wherein said second grating structure is a mathematical image of said first grating structure by rotating said first grating structure over an angle of rotation.

15. Device according to claim 14, wherein said means arranged for replacing said first grating structure are arranged for rotating said first diffraction grating around an axis of rotation transverse to said at least one primary laser beam.

16. Diffraction grating for use in a method according to any of the claims 1-9, said diffraction grating comprising a first part having a first grating structure and a second part having a second grating structure.

17. Diffraction grating according to claim 16, wherein said second grating structure is a mathematical image of said first grating structure by rotating said first grating structure over an angle of rotation.

18. Diffraction grating according to claim 17, wherein said rotation angle is a straight angle.
